**Europäisches Patentamt**

**European Patent Office**

**Office européen des brevets**

(19)

(11) Veröffentlichungsnummer: **0 141 925 B1**

# (12) EUROPÄISCHE PATENTSCHRIFT

(45) Veröffentlichungstag der Patentschrift:
25.11.87

(21) Anmeldenummer: 84109461.8

(22) Anmeldetag: 08.08.84

(51) Int. Cl.⁴: **H 03 C 1/16**, H 03 K 7/08

(54) Schaltungsanordnung zur Verhinderung von Bremsfeldschwingungen in Elektronenröhren, insbesondere für eine Pulsdauermodulationsstufe in Sendeanlagen.

(30) Priorität: 30.08.83 DE 3331267

(43) Veröffentlichungstag der Anmeldung:
22.05.85 Patentblatt 85/21

(45) Bekanntmachung des Hinweises auf die Patenterteilung:
25.11.87 Patentblatt 87/48

(84) Benannte Vertragsstaaten:
CH DE FR GB LI NL

(56) Entgegenhaltungen:
DE-C-568 768
DE-C-949 831
DE-C-966 030
FR-A-2 386 935
US-A-3 179 893

(73) Patentinhaber: Siemens Aktiengesellschaft Berlin
und München, Wittelsbacherplatz 2, D-8000
München 2 (DE)

(72) Erfinder: Stahl, Jochen, Ing. grad.,
Xantenerstrasse 15a, D-1000 Berlin 15 (DE)
Erfinder: Beling, Ingo, Ing. grad., Baluschekweg
59, D-1000 Berlin 20 (DE)

## Beschreibung

Die Erfindung betrifft eine Schaltungsanordnung zur Verhinderung von Bremsfeldschwingungen in Elektronenröhren, insbesondere für eine Pulsdauermodulationsstufe in Sendeanlagen.

Betreibt man Elektronenröhren im sogenannten überspannten Betrieb, d. h. die Anodenspannung liegt unter der Gitterspannung, dann treten bei entsprechenden Elektronendichten Bremsfeldschwingungen auf. Diese Schwingungen werden auch Barkhausen-Kurz-Schwingungen genannt (man vgl. Rint, Lexikon der Hochfrequenz-, Nachrichten- und Elektrotechnik, Bd. 1, 1957, Seiten 527 und 528). Die Frequenz dieser Schwingungen ist von den anliegenden Elektrodenspannungen abhängig.

Bremsfeldschwingungen treten sowohl bei Trioden als auch bei Tetroden auf.

Durch äußere Dämpfung können diese Schwingungen nicht ververhindert werden. Man kann sie nur verhindern, indem man die Anodenspannung nicht so niedrig bzw. den Elektronenstrom nicht so hoch werden läßt, daß sich die Bremsfeldschwingungen ausbilden können.

Das ist schaltungstechnisch in vielen Anwendungsfällen möglich. In sogenannten PDM- (Pulsdauermodulierten-) Sendern würden diese Maßnahmen zu einer Verschlechterung des Modulatorwirkungsgrades führen.

Der vorliegenden Erfindung liegt daher die Aufgabe zugrunde, eine Regelschaltung zum Vermeiden der Betriebszustände zu schaffen, die zum Anschwingen der Bremsfeldschwingungen führen.

Diese Aufgabe wird bei einer Schaltungsanordnung der eingangs genannten Art erfindungsgemäß dadurch gelöst, daß ein Netzteil zur Erzeugung einer Spannung zur Unterdrückung von Bremsfeldschwingungen über eine zwischen der Anode der Schaltröhre und dem positiven Pol dieser Spannung eingeschalteten Zuführungsdiode parallel zu der Schaltröhre geschaltet ist.

Durch die erfindungsgemäße Schaltungsanordnung wird erreicht, daß die Anode der PDM-Schaltröhre in keinem Betriebszustand eine vorgegebene Spannung unterschreitet, so daß keine Bremsfeldschwingungen auftreten. Die durch diese Stromversorgung aufzubringende Leistung ist niedrig, so daß sich der Anodenwirkungsgrad der Schaltröhre nur wenig verschlechtert. Durch die Anpassung der zusätzlichen Anodenspannungsquelle an die Röhrentype kann die Wirkung der Schaltungsanordnung optimiert werden. Die Größe der Spannung $U_{Br}$ (Bremsfeldspannung) liegt je nach Röhrentyp bei 50 bis 300 V. Der Strom ist von der Leistung der Pulsdauermodulationsstufe abhängig.

Weitere Einzelheiten der Erfindung werden anhand eines in den Figuren der Zeichnung dargestellten Ausführungsbeispiels näher erläutert.

Dabei zeigen:

Fig. 1 Eine Schaltungsanordnung gemäß der Erfindung,

Fig. 2 ein Diagramm des Anodenspannungsverlaufs ohne Netzteil und Zuführungsdiode für die Bremsfeldspannung gemäß der Schaltungsanordnung nach Fig. 1 und

Fig. 3 ein Diagramm über den Anodenspannungsverlauf der erfindungsgemäßen Schaltungsanordnung.

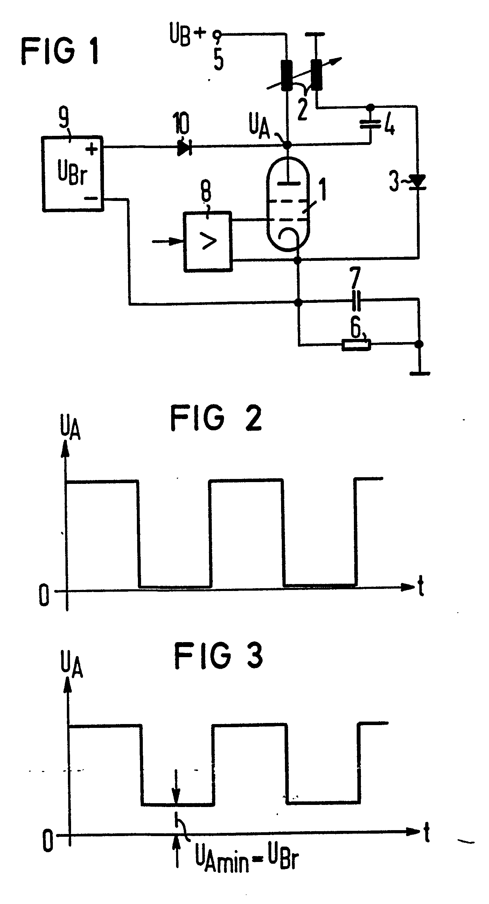

In Figur 1 ist eine Schaltungsanordnung zur Verhinderung von Bremsfeldschwingungen von Elektronenröhren am Beispiel einer Pulsdauermodulationsstufe dargestellt. Das Netzteil 9 zur Erzeugung der Bremsfeldspannung $U_{Br}$ ist über eine zwischen der Anode der Schaltröhre 1, in diesem Beispiel einer Tetrode, und dem positiven Pol dieser Spannung $U_{Br}$ eingeschalteten zuführungsdiode 10 parallel zu der Schaltröhre 1 geschaltet. Die Versorgungsspannung 5 (Batteriespannung $U_B$) ist an die Anode der Schaltröhre 1 über eine Impuls-Doppeldrossel 2 angelegt, in deren einem Zweig ein Koppelkondensator 4 angeordnet ist. Parallel zur Schaltröhre 1 ist zwischen der Kathode der Röhre 1 und der Impuls-Doppeldrossel 2 eine Freilaufdiode 3 geschaltet. Der Ansteuerverstärker 8 ist parallel zur Kathode und dem Steuergitter der Schaltröhre 1 geschaltet. Das pulsdauermodulierte Signal wird dem Verbraucher 6 (Senderendstufe), dem ein Siebkondensator 7 parallel geschaltet ist, zugeführt.

Fig. 2 zeigt ein Diagramm über den Anodenspannungsverlauf $U_A$ der Schaltröhre 1 des Ausführungsbeispiels ohne Netzteil 9 und Zuführungsdiode 10 für die Bremsfeldspannung $U_{Br}$.

Fig. 3 zeigt ein Diagramm über den Anodenspannungsverlauf $U_A$ der Schaltröhre 1 des erfindungsgemäßen Ausführungsbeispiels mit Netzteil 9 und Zuführungsdiode 10 für die Bremsfeldspannung $U_{Br}$.

Das Anodenspannungsminimum $U_{A_{min}}$ ist gleich der Bremsfeldspannung $U_{Br}$.

## Patentanspruch

1. Schaltungsanordnung zur Verhinderung von Bremsfeldschwingungen in Elektronenröhren, insbesondere für eine Pulsdauermodulationsstufe in Sendeanlagen,

dadurch gekennzeichnet, daß ein Netzteil (9) zur Erzeugung einer Spannung ($U_{Br}$) zur Unterdrückung von Bremsfeldschwingungen über eine zwischen der Anode der Schaltröhre (1) und den positiven Pol dieser Spannung ($U_{Br}$) eingeschalteten zzuführungsdiode 10 parallel zu der Schaltröhre (1) geschaltet ist.

## Claim

1. A circuit arrangement for preventing retarding field oscillations in electron tubes, in particular for a pulse duration modulation stage in transmitting systems, <u>characterised in that</u> a power supply unit (9) which serves to produce a voltage ($U_{br}$) to suppress retarding field oscillations is connected parallel to the tube (1) by a supply diode (10) connected between the anode of the tube (1) and the positive pole of this voltage ($U_{br}$).

## Revendication

1. Montage pour empêcher les oscillations de champ retardateur dans des tubes électroniques, en particulier pour un étage de modulation d'impulsions en durée d'installations d'émission, caractérisé en ce qu'un bloc d'alimentation (9), destiné à générer une tension ($U_{Br}$) pour supprimer des oscillations de champ retardateur, est connecté en parallèle avec le tube commutateur (1) à travers une diode d'alimentation (10) montée entre l'anode du tube commutateur (1) et le pôle positif de cette tension ($U_{Br}$).

FIG 1

FIG 2

FIG 3

$U_{Amin} = U_{Br}$

0 141 925